# EUROPÄISCHE PATENTSCHRIFT

(11) **EP 0 736 110 B1**
(45) Veröffentlichungstag und Bekanntmachung des Hinweises auf die Patenterteilung: **12.08.1998**
(21) Anmeldenummer: 95901394.7
(22) Anmeldetag: 18.11.1994
(51) Int. Cl.: C23C 16/04, C23C 16/48, C23C 16/00

(54) **VERFAHREN UND EINRICHTUNG ZUM ERZEUGEN DREIDIMENSIONALER STRUKTUREN DURCH OPTISCH STIMULIERTE MATERIALABSCHEIDUNG AUS EINER FLUIDEN VERBINDUNG**
PROCESS AND DEVICE FOR PRODUCING THREE-DIMENSIONAL STRUCTURES BY THE OPTICALLY STIMULATED SEPARATION OF MATERIAL FROM A FLUID COMPOUND
PROCEDE ET DISPOSITIF PERMETTANT DE REALISER DES STRUCTURES TRIDIMENSIONNELLES PAR DEPOT CHIMIQUE STIMULE DE MANIERE OPTIQUE D'UN MATERIAU RESULTANT DE LA DECOMPOSITION D'UN COMPOSE FLUIDE

(30) Priorität: 19.11.1993 DE 4339550
(43) Veröffentlichungstag der Anmeldung: 09.10.1996
(73) Patentinhaber: Max-Planck-Gesellschaft zur Förderung der Wissenschaften e.V., 80539 München (DE)
(72) Erfinder: LEHMANN, Olaf, D-37077 Göttingen (DE); STUKE, Michael, D-37077 Göttingen (DE)
(74) Vertreter: Hertz, Oliver, Dr.
(86) Internationale Anmeldenummer: EP9403821
(87) Internationale Veröffentlichungsnummer: WO9514115

(56) Entgegenhaltungen:
- CHEMICAL ABSTRACTS, vol. 122 Columbus, Ohio, US; abstract no. 92666, LEHMANN, O. ET AL 'Three - dimensional laser direct writing of electrically conducting and isolating microstructures'
- PATENT ABSTRACTS OF JAPAN vol. 8, no. 84 (E-239) (1521) 18. April 1984 & JP,A,59 005 621 (NIPPON DENKI) 12. Januar 1984
- JOURNAL OF APPLIED PHYSICS., Bd.72, Nr.12, 15. Dezember 1992, NEW YORK US Seiten 5956 - 5963 JOHANSSON ET AL. 'Microfabrication of three-dimensional boron structures by laser chemical processing'

## Beschreibung

Die vorliegende Erfindung betrifft ein Verfahren und eine Einrichtung zum Erzeugen dreidimensionaler Strukturen durch optisch stimuliertes Abscheiden von Strukturmaterial aus einer fluiden (dampfförmigen oder flüssigen) Verbindung.

Bei einem als Laser-Direktschreibverfahren (englisch LCVD für Laser assisted Chemical Vapor Deposition) bekannten Verfahren dient ein auf eine ebene Substratoberfläche fokussierter Laserstrahl zur lokalen Erwärmung des Substrats im Fokusbereich. Das Substrat befindet sich hierbei z. B. in einer reaktiven Dampfatmosphäre. In der erwärmten Zone wird eine chemische Reaktion ausgelöst, bei der Moleküle einer gasförmigen Verbindung an der Substratoberfläche thermisch zerlegt werden. Dabei scheidet sich ein bestimmter Bestandteil dieser Moleküle auf der Substratoberfläche ab, z.B. ein Metall, wenn eine metallorganische gasförmige Verbindung benutzt wird, und zwar nur in dem sehr begrenzten Bereich, der durch den Laserstrahl erhitzt wird. Werden nun das Substrat und der Laserstrahlfokus in der Substratebene in Bezug aufeinander bewegt, so wandert auch die erhitzte Zone auf der Oberfläche des Substrats. Auf diese Weise lassen sich Bahnen aus dem abgeschiedenen Material (Strukturmaterial) auf die Substratoberfläche "schreiben".

Es ist auch schon bekannt, freitragende dreidimensionale, stab- und wendelförmige Strukturen aus Silizium, Bor oder Kohlenstoff durch LCVD herzustellen und auf einen Stab aus Silizium eine Wendel aus Wolfram durch LCVD aufzubringen (Leyendecker et al., Appl. Phys. Lett. **39** (11), 1. Dezember 1981, 921-923; Bäuerle et al., Appl. Phys. A, 147-149 (1983); Boman et al., Micro Electro Mechanical Systems '92, Travemünde (Germany), February 4-7, 1992, S. 162-167. Bei diesen Verfahren wird ein Laserstrahl mit ausreichender Energiedichte auf eine Substratoberfläche fokussiert. Nachdem auf der Substratoberfläche etwas Strukturmaterial abgeschieden worden ist, werden der Fokus und die Substratoberfläche mit einer Geschwindigkeit voneinander entfernt, die höchstens gleich der Wachstumsgeschwindigkeit des Strukturmaterials in Richtung der Relativbewegung ist, so daß auf dem Substrat ein dünner Stab aus dem Strukturmaterial aufwächst.

Der Grund für das Enstehen des Stabes 14 ist folgender: Bei im wesentlichen undurchsichtigen Materialien, wie z.B. Kohlenstoff (Graphit) wird an der Oberfläche des bereits abgeschiedenen Materials praktisch die ganze auftreffende optische Strahlung absorbiert. Das abgeschiedene Material ist daher an der dem Laserstrahl zugewandten Oberfläche besonders heiß, die Temperatur im Inneren des abgeschiedenen Materials fällt entsprechend der Wärmeleitungseigenschaften des Materials exponentiell ab. Die thermische Zersetzung der das Strukturmaterial liefernden Verbindung findet also in erster Linie an der dem Laserstrahl zugewandten und durch den Laserfokus erhitzten Oberseite des abgeschiedenen Strukturmaterials statt. Das Wachstum ist daher zum Laserstrahl hin gerichtet. Dieser Effekt wird noch verstärkt durch die Tatsache, daß das neu abgeschiedene Material das Laserlicht absorbiert, so daß sich die heißeste Stelle in Richtung des Laserstrahls verschiebt.

Der vorliegenden Erfindung liegt die Aufgabe zugrunde, ein optisches LCVD-Direktschreibverfahren und eine Einrichtung zur Durchführung eines solchen Verfahrens anzugeben, mit dem sich in den Raum erstreckende Strukturen, insbesondere auch aus schwach absorbierenden, praktisch durchsichtigen Materialien erzeugt werden können und das außerdem eine bessere Steuerung der Wachs- oder Züchtungsrichtung ermöglicht.

Diese Aufgabe wird durch das Verfahren gemäß dem Anspruch 1 und die Einrichtung gemäß dem Anspruch 3 gelöst.

Das Verfahren und die Einrichtung gemäß der Erfindung eignen sich insbesondere zur Herstellung von dreidimensionalen Strukturen aus schwach absorbierenden Materialien. Die Richtung, in der das Material abgeschieden wird und die Struktur wächst, läßt sich besonders gut steuern.

Im folgenden wird die Erfindung unter Bezugnahme auf die Zeichnungen näher erläutert. Es zeigen:
- Fig. 1: eine schematische Darstellung zur Erläuterung einer Ausführungsform der vorliegenden Erfindung, und
- Fig. 2: eine vereinfachte Darstellung einer Einrichtung zur Durchführung des Verfahrens gemäß der Erfindung.

Bei dem vorliegenden Verfahren wird von der bekannten LCVD-Technik Gebrauch gemacht, bei der ein Substrat in einer geschlossenen Kammer angeordnet wird, in der sich eine Atmosphäre oder ein Medium befinden, die eine thermisch oder optisch zersetzbare chemische Verbindung enthalten. Die Wand der Kammer hat gewöhnlich ein Fenster zur Einführung der die Zersetzung bewirkenden Laserstrahlung.

Schwach absorbierende, weitgehend transparente Strukturmaterialien mit größerer Absorptionslänge zeigen ein anderes Verhalten. Schwach absorbierende Materialien sind solche, bei denen die Absorptionslänge oder Eindringtiefe (die Strecke bis zum Absinken der Strahlungsintensität auf das 1/e-fache der Anfangsintensität) in der Größenordnung der Strukturdurchmesser liegt. Bei einem Stabdurchmesser von z.B. 10 µm, wie er für das vorliegende Verfahren typisch ist, liegt die Absorptionslänge also in der Größenordnung von 5 bis 10 µm. Da hier der Laserstrahl eine erhebliche Strecke in das abgeschiedene Material eindringen kann, ist das Temperaturprofil in Achsrichtung des Laserstrahls wesentlich weniger steil. Die Richtungscharakteristik für das Wachstum des Strukturmaterials ist dann wesentlich weniger ausgeprägt.

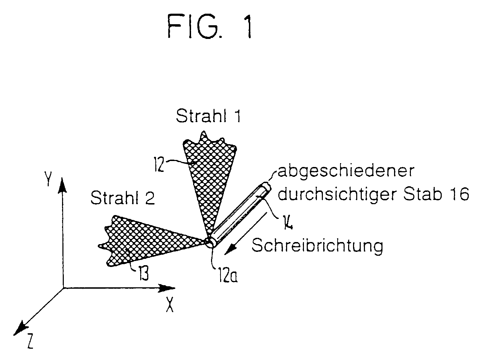

Die in Fig. 1 dargestellte Ausführungsform des erfindungsgemäßen Verfahrens eignet sich besonders, jedoch nicht ausschließlich, für die Herstellung von beliebig gerichteten, insbesondere stabförmigen Strukturen aus schwach absorbierenden Strukturmaterialien. Hier wird außer einem ersten Laserstrahl 12 noch ein zweiter fokussierter Laserstrahl 13 verwendet, dessen Fokus mit dem Fokus 12a des ersten Laserstrahls im wesentlichen zusammenfällt. Die Leistung jedes einzelnen Strahles wird so gering bemessen, daß ein gerichtetes Wachstum in Richtung eines der beiden Strahlen so gut wie gar nicht mehr stattfindet. Im Schnittpunkt der beiden fokussierten Strahlen 12, 13 wird durch das bestrahlte Material aber pro Volumeneinheit mehr Licht absorbiert als in der Umgebung. Daher befindet sich die heißeste Stelle im Schnittpunkt beider Laserstrahlen oder in dessen Nähe. Das Temperaturprofil hat also näherungsweise eine Radialsymmetrie. Das Wachstum.des Strukturmaterials ist deshalb auch im wesentlichen ungerichtet. Durch Bewegung des Schnittpunkts der Laserstrahlen kann dann eine beliebige Wachstumsrichtung im Dreidimensionalen vorgegeben werden, insbesondere auch senkrecht zu den Achsen der beiden Strahlen, wie in Fig. 1 durch einen Pfeil angedeutet ist.

Mit dem Verfahren gemäß Fig. 1 ist es möglich, aus Stäben bestehende oder zusammengesetzte und andere dreidimensionale Strukturen zu erzeugen, die praktisch jede denkbare Form haben können. Die Querdimensionen (Durchmesser) werden dabei im allgemeinen im Sub-Millimeterbereich und darunter liegen.

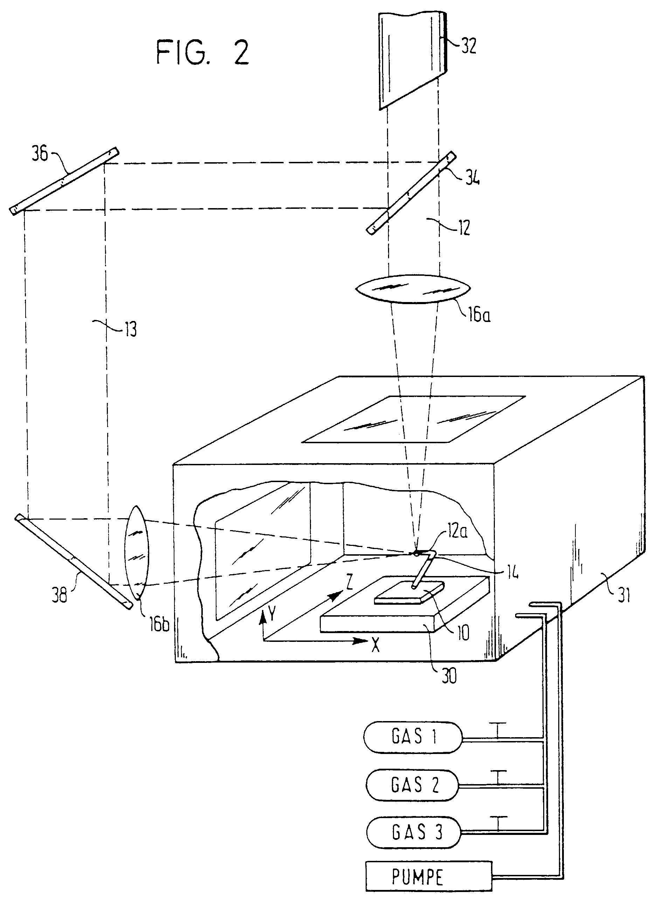

Die in Fig. 2 dargestellte Einrichtung enthält einen Koordinatentisch 30, mit dem ein Substrat 10 in drei Richtungen x, y und z bewegt werden kann. In Spezialfällen können weitere Bewegungs-Freiheitsgrade in Form von Rotationsachsen sinnvoll sein, z. B. können insgesamt bis zu sechs Bewegungs-freiheitsgrade vorgesehen sein, d. h. drei Translationsachsen x, y, z und drei Rotationsachsen. Das Substrat befindet sich in bekannter Weise in einer nur schematisch angedeuteten evakuierbaren Kammer 31, an die in bekannter Weise ein Pumpsystem sowie ein Gasversorgungssystem angeschlossen sind.

Zum Erzeugen von zwei fokussierten Laserstrahlen dient ein Laser 32, z.B. Ar⁺-Laser (λ = 514 nm). Der vom Laser erzeugte Laserstrahl wird durch einen Strahlteiler 34 in zwei Teilstrahlen gleicher Intensität aufgeteilt, von denen der eine durch ein erstes Linsensystem 16a in einen Fokus 12a fokussiert wird während der zweite Teilstrahl 13 durch Umlenkspiegel 36, 38 umgelenkt und durch ein zweites Linsensystem 16b in den Fokus 12a fokussiert wird. Das Linsenund Spiegelsystem und der Laser können sich außerhalb der Kammer 31 befinden. Zum Erzeugen der beiden Strahlungsbündel 12, 13 können auch zwei getrennte Laser oder andere optische Strahlungsquellen ausreichender Intensität verwendet werden.

Die beiden Laserstrahlungsbündel 12, 13 können auch durch zwei verschiedene Laser erzeugt werden, die Licht verschiedener Wellenlängen emittieren. In Verbindung mit einem chemischen Prozeß, der nur abläuft, wenn beide Laserstrahlen vorhanden sind, ließe sich die Ortsdefinition noch verbessern. Z.B. könnte ein Laser eine Reaktion vorbereiten, die der andere vollendet. Die Gesamtreaktion könnte dann nur im Schnittpunkt beider Strahlen ablaufen.

Für die Materialabscheidung können Verbindungen, wie sie für die bekannten zweidimensionalen Laser-CVD-Direktschreibverfahren bekannt sind, verwendet werden.

Ein geeignetes Material ist z.B. Aluminiumoxid (Al₂O₃), das aus der metallorganischen Aluminiumverbindung Trimethylamin-Alan (TMAA) und Sauerstoff abgeschieden werden kann. Weiterhin möglich ist Siliziumoxid (SiO₂), das aus Silan oder Disilan und Lachgas (N₂O) abgeschieden werden kann, und andere kristalline Materialien, z.B. weitere Metalloxidverbindungen, die teilweise interessante Eigenschaften, etwa piezoelektrische, haben. Isolierende Strukturen, z.B. Aluminiumoxidstrukturen können nachträglich selektiv mit Aluminium überzogen werden, wenn eine reine Atmosphäre einer aluminiumhaltigen Verbindung, z.B. TMAA oder Triethylamin-Alan (TEAA), verwendet wird. So lassen sich leitende und isolierende Strukturen z.B. zu Elektrodenstrukturen zusammenfügen, die als elektronen- oder ionenoptische Bauteile Verwendung finden könnten.

Die Hauptanwendung des vorliegenden Verfahrens dürfte die Herstellung mikromechanischer Bauelemente sein. Der direkte Zugang zur dritten Dimension macht das vorliegende Verfahren gegenüber gebräuchlichen Lithographie- und Ätztechniken, die im wesentlichen 2 1/2-dimensionale Strukturen erzeugen können, für die Herstellung mikrotechnischer Sensoren und Aktoren interessant.

## Patentansprüche

1. Verfahren zum Erzeugen einer Struktur aus einem Strukturmaterial auf einem Substrat, bei welchem das Strukturmaterial durch Zersetzung einer gasförmigen Verbindung im Fokus eines Laserstrahlungsbündels auf der Oberfläche eines Substrats abgeschieden wird, der Fokus (12a) und die Substratoberfläche (10a) zur Bildung einer sich von der Substratoberfläche weg erstreckenden Struktur mit einer Geschwindigkeit voneinander entfernt werden, die höchstens gleich der Aufwachsgeschwindigkeit des abgeschiedenen Materials in der Richtung der Bewegung des Fokus bezüglich des Substrates ist, **dadurch gekennzeichnet,** daß ein zweites Laserstrahlungsbündel (13) in den Fokus (12a) des ersten Laserstrahlungsbündels (12) fokussiert wird und daß die zusammenfallenden Foken gemeinsam bezüglich des Substrats bewegt werden.

2. Verfahren nach Anspruch 1, **dadurch gekennzeichnet,** daß eine Verbindung verwendet wird, die bei ihrer thermischen Zersetzung ein Substratmaterial liefert, welches die Laserstrahlung relativ schwach absorbiert.

3. Einrichtung zur Durchführung des Verfahrens nach Anspruch 1, mit einer Kammer zur Aufnahme eines Substrats, eine Einrichtung zum Erzeugen einer Atmosphäre in der Kammer, die eine Verbindung enthält, die bei thermischer Zersetzung durch optische Strahlung ein gewünschtes Strukturmaterial liefert, einer Vorrichtung zur Halterung eines Substrats (10) in der Kammer, eine Vorrichtung zum Erzeugen und Fokussieren eines Laserstrahlungsbündels (12) auf die Oberfläche des Substrats, einer Vorrichtung zum Bewegen des Substrats bezüglich des Fokus des Laserstrahlungsbündels und eine Vorrichtung zum Wegbewegen des Fokus der optischen Strahlung von der Substratoberfläche, **gekennzeichnet durch** eine Vorrichtung zum Erzeugen und Fokussieren eines zweiten Laserstrahlungsbündels (13) in den Fokus des ersten Laserstrahlungsbündels (12).

4. Einrichtung nach Anspruch 3, **gekennzeichnet durch** einen einzigen Laser (32) und einen Bündelteiler (34) zum Erzeugen der beiden Laserstrahlungsbündel.

5. Einrichtung nach Anspruch 3, **gekennzeichnet durch** zwei Laser zum Erzeugen der beiden Laserstrahlbündel.

6. Einrichtung nach Anspruch 5, **dadurch gekennzeichnet,** daß die Laser verschiedene Emissionswellenlängen haben.

## Claims

1. A method of producing a structure from a structural material on a substrate, wherein the structural material is deposited on the surface of a substrate by decomposition of a gaseous compound in the focus of a laser radiation beam, the focus (12a) and the substrate surface (10a) are moved away from one another to form a structure extending away from the substrate surface, with a speed which is equal at the most to the rate of growth of the deposited material in the direction of movement of the focus relative to the substrate, characterized in that a second laser radiation beam (13) is focused in the focus (12a) of the first laser radiation beam (12) and in that the coincident foci are moved in common relative to the substrate.

2. A method according to claim 1, characterized in that a compound is employed which yields a substrate material from its thermal decomposition, which absorbs the laser radiation relatively weakly.

3. A device for carrying out the method according to claim 1, with a chamber for receiving a substrate, a device for creating an atmosphere in the chamber containing a compound which yields a desired structural material when thermally decomposed, a device for holding a substrate (10) in the chamber, a device for creating and focussing a laser radiation beam (12) on the surface of the substrate, a device of moving the substrate relative to the focus of the laser radiation beam and a device for moving the focus of the optical radiation away from the substrate surface, characterized by a device for creating and focussing a second laser radiation beam (13) in the focus of the first laser radiation beam (12).

4. A device according to claim 3, characterized by a single laser (32) and a beam splitter (34) for creating the two laser radiation beams.

5. A device according to claim 3, characterized by two lasers for creating the two laser radiation beams.

6. A device according to claim 5, characterized in that the lasers have different emission wavelengths.

## Revendications

1. Procédé de fabrication d'une structure, à partir d'une matière de la structure, sur un substrat dans lequel on dépose la matière de la structure, sur la surface d'un substrat, par décomposition d'un composé gazeux à l'endroit du foyer d'un faisceau de rayonnement laser, on déplace, l'un par rapport à l'autre et à une vitesse donnée, le foyer (12a) et la surface (13a) du substrat afin de former une structure s'étendant à distance de la surface du substrat, la vitesse de déplacement étant au plus égale à la vitesse de croissance du matériau déposé dans la direction du mouvement du foyer par rapport au substrat, caractérisé en ce qu'on focalise un second faisceau de rayonnement laser (13) à l'endroit du foyer (12a) du premier faisceau de rayonnement laser (12) et on déplace conjointement, par rapport au substrat, les foyers confondus.

2. Procédé suivant la revendication 1 caractérisé en ce qu'on utilise un composé qui, par suite de sa décomposition thermique, produit une matière de substrat qui absorbe relativement faiblement le rayonnement laser.

3. Dispositif pour la mise en oeuvre du procédé suivant la revendication 1, comportant une chambre pour le logement d'un substrat, un dispositif pour produire une atmosphère dans la chambre contenant un composé qui, par suite de sa décomposition thermique sous l'effet du rayonnement optique, produit une matière de structure désirée, un dispositif pour maintenir un substrat (10) dans la chambre, un dispositif pour produire et focaliser un faisceau de rayonnement laser (12) sur la surface du substrat, un dispositif pour déplacer le substrat par rapport au foyer du faisceau de rayonnement laser et un dispositif pour éloigner le foyer du rayonnement optique à partir de la surface du substrat, caractérisé en ce qu'il comprend un dispositif pour produire et focaliser un second faisceau de rayonnement laser (13) à l'endroit du foyer du premier faisceau de rayonnement laser (12).

4. Dispositif suivant la revendication 3 caractérisé en ce qu'il comporte un seul laser (32) et un séparateur de faisceaux (34) pour produire les deux faisceaux de rayonnement laser.

5. Dispositif suivant la revendication 3 caractérisé en ce qu'il comporte deux lasers pour produire les deux faisceaux de rayonnement laser.

6. Dispositif suivant la revendication 5 caractérisé en ce que les lasers ont des longueurs d'onde d'émission différentes.
